# EUROPEAN PATENT SPECIFICATION

(11) **EP 0 384 673 B1**
(45) Date of publication and mention of the grant of the patent: **24.05.1995**
(21) Application number: 90301733.3
(22) Date of filing: 16.02.1990
(51) Int. Cl.: G11C 7/00, G11C 11/419

(54) **Memory devices**
Speicheranordnungen
Dispositifs de mémoire

(30) Priority: 18.02.1989 JP 39039/89; 21.02.1989 JP 39410/89
(43) Date of publication of application: 29.08.1990
(60) Divisional application: 94200916.8
(73) Proprietor: SONY CORPORATION, Tokyo 141 (JP)
(72) Inventor: Suzuki, Hiroyuki, c/o Patents Division, Shinagawa-ku, Tokyo 141 (JP); Araki, Shigeo, c/o Patents Division, Shinagawa-ku, Tokyo 141 (JP)
(74) Representative: Cotter, Ivan John

(56) References cited:
- EP-A- 0 121 208
- US-A- 4 355 377
- US-A- 4 712 194

## Description

This invention relates to memory devices.

In general, in a static random access memory (SRAM), which is a type of semiconductor memory device, a signal potential difference is produced across a pair of bit lines ora pair of common data lines in order to effect data readout or data writing. For high speed readout or writing operations, it is necessary to change the logic level quickly. Thus, a known technique provides for shorting a pair of bit lines or a pair of common data lines, across which the signal potential difference is produced, for equalising the logic level for the next data. When bit lines having a logic level opposite to that of a memory cell of the SRAM are connected to the cell at the time of row selection, the data on the cell occasionally may be reversed. Thus, there is also known a precharging technique of transiently raising the bit line voltage towards the source voltage prior to row selection (word line selection) of the bit lines.

Such equalising or precharging is usually performed at the time of the writing or reading and before row selection. The timing is produced by an address transition detection circuit (ATD) operative to generate pulses upon address changes. For example, according to Japanese Patent Application Publication no. JP-A-57 74 884 or US Patent No. US-A-4 355 377, pulses are generated in the address transition detection circuit in response to address changes and are transmitted to a clock generator. The signals for controlling the equalising or precharging are outputted from the clock generator to actuate the equalising or precharging circuits provided on the bit line pairs to shorten the access time.

However, in general, during transition from the write operation to the readout operation, the bit lines or the common data lines are substantially in what is referred to as a fully swung state. For this reason, such an amount of time is needed for equalising or precharging that, when the speed is to be increased, it becomes difficult to terminate the equalising or precharging operation before word line selection.

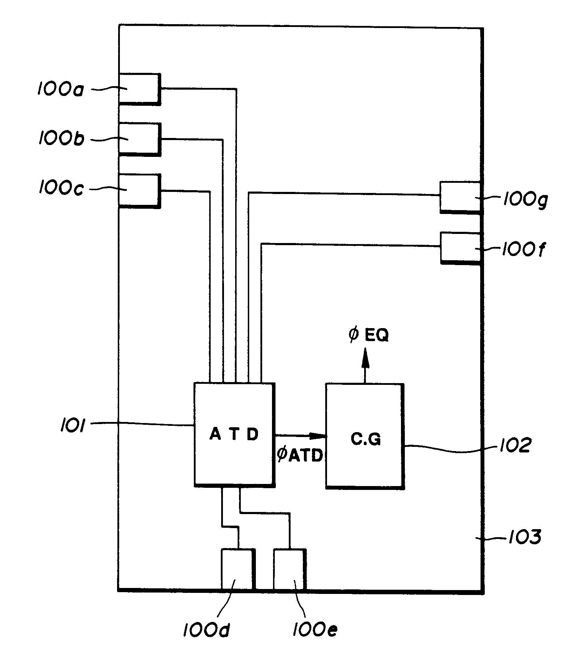

If pulses are produced more promptly from the address transition detection circuit, the equalising or precharging operation can be terminated more promptly. However, as shown diagrammatically in Figure 1 of the accompanying drawings, the address transition detection (ATD) circuit 101 collects the data at address inputs 1 OOa to 1 OOg, detects address data transitions and transmits a signal ϕATD comprising pulses to a clock generator (CG) 102. The address inputs 100a to 100g are widely distributed on a chip 103, so that it is extremely difficult to detect a data transition of each address at high speed. The greater the number of addresses, the larger is the scale of the address transition detection circuit 101 and the longer is the time involved until pulse generation.

The above-described problem arises during transition from writing to readout of the SRAM data.

US Patent US-A-4 712 194 discloses a memory device comprising:
a plurality of memory cells arranged in a matrix configuration and composed of flip-flop circuits for data storage;
a plurality of pairs of bit lines, each coupled to a column of the memory cells, for handling complementary read-out data or write data;
a plurality of word lines, one for each row of the memory cells, for selecting rows of the memory cells;
a sense amplifier connectable to a pair of bit lines for amplifying the voltage across the pair of bit lines;

bit line equalising means (referred to as "first precharging means") operative transiently prior to memory cell selection by a word line to equalise a pair of the bit lines by setting the lines to the same potential;

equalising control means for setting the operating time interval for the bit line equalising means;

first signal generating means responsive to an address signal supplied for selection of the word lines and the bit lines to generate a signal for actuating the equalising control means;

bit line precharging means (referred to as "second precharging means") operative transiently prior to memory cell selection by a word line to precharge a pair of the bit lines by connecting the lines to a potential source;

precharging control means for setting the operating time interval of the bit line precharging means; and

second signal generating means operative to detect a transition from writing to read-out and to actuate the precharing control means at the time said transition is detected.

Thus, while US-A-4 712 194 contemplates precharging of the bit lines on transition from writing to read-out, like the above-cited prior art it equalises the bit lines in response to the address signals.

In US-A-4 355 377 (cited above), both precharging and equalising (referred to as "equilibrating") of the bit lines is carried out in response to transitions in the address signals. US-A-4 355 377 also discloses the possibility of equilibrating data line pairs connected to respective bit line pairs.

Respective different aspects of the invention are set out in claims 1 and 3, the first or pre-characterising parts of both of which are based upon US-A-4 712 194.

According to an aspect of the invention there is provided a memory device which includes a signal generator operative to detect a transition from writing to readout (for example a pulse generator operative to produce a pulse on detection of such a transition), the common data lines being equalised and/or precharged when such a transition is detected (for example when a pulse is produced). A write enable signal may be used as a signal enabling detection of a transition from writing to readout.

Thus, a high-speed common data line equalising and/or precharging operation can be performed at the time of transition from a writing operation to a read- out operation.

According to an embodiment of the invention, a pulse signal from the above-mentioned pulse generator is transmitted to a bit line equalising control circuit, a bit line precharging control circuit, a common data line equalising control circuit, and a common data line precharging control circuit. Control signals for equalising and/or precharging circuits are transmitted from each of the foregoing control circuits. For operations other than those during transition from writing to readout, each control circuit receives not only the pulse signal from the pulse generator but also a signal from an address transition detection circuit.

Embodiments of the invention described in detail hereinbelow provide a semiconductor memory device that can be arranged for use as a static random access memory (SRAM), and which has a large capacity and can operate at high speed.

The invention will now be further described, by way of illustrative and non-limiting example, with reference to the accompanying drawings, in which:
Figure 1 is a diagrammatic view of a chip of a previously proposed semiconductor memory device;
Figure 2 is a block diagram showing the arrangement of a typical semiconductor memory device embodying the invention;
Figure 3 is a circuit diagram showing parts of the device of Figure 2;
Figure 4 is a timing chart showing the operation of a ϕEQW generating circuit of the device of Figure 2;
Figure 5 is a circuit diagram showing an example of the ϕEQW generating circuit; and
Figure 6 is a timing chart for illustrating the operation of the device of Figure 2.

A SRAM forming a preferred illustrative embodiment of the invention will now be described in detail with reference to the drawings.

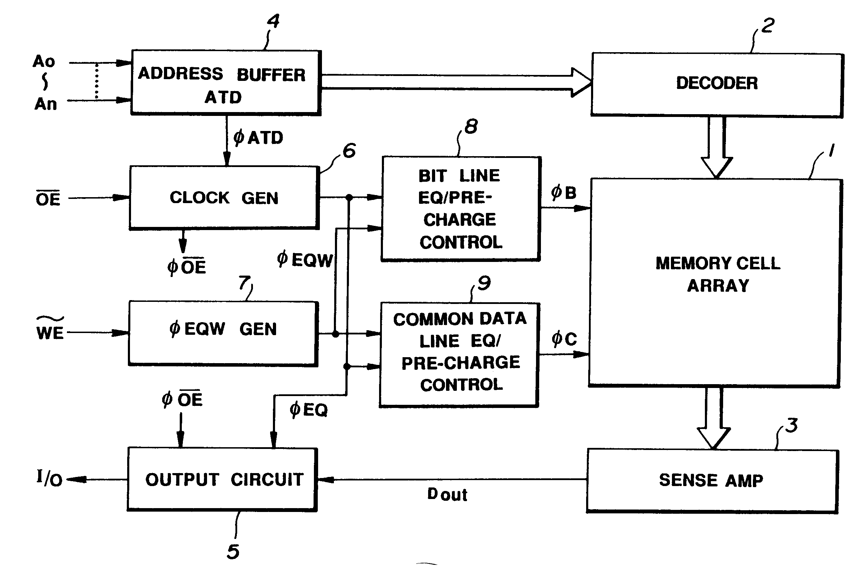

Figure 2 shows schematically the overall construction of the SRAM, which is of complementary metal oxide semiconductor (CMOS) structure. The circuitry of the SRAM is constituted by MOS transistors formed on a major surface of a semiconductor substrate and includes an address buffer-address transition detection (ATD) circuit 4 to which address signals AO to An are inputted and from which address data are transmitted to a decoder 2. Memory cell selection signals are transmitted from the decoder 2 to a memory cell array 1 where a desired memory cell is selected and corresponding data are read out. The data from the memory cell array 1 are amplified by a sense amplifier 3 from which data output signals Dout are transmitted to an output circuit 5.

An address transition detection signal ϕATD, which is a pulse signal comprising pulses generated by transitions of the address signals AO to An, is outputted from the address buffer-ATD circuit 4 and transmitted to a clock generator 6, in which an equalising pulse signal ϕEQ is generated on the basis of the pulses of the address transition detection signal ϕATD. An output enable signal OE is inputted from outside to the clock generator 6 so as to be supplied to the output circuit 5 as a signal ϕOE. The equalising signal ϕEQ is also transmitted to the output circuit 5. Thus, the data signal Dout, the equalising signal ϕEQ and the signal ϕOE are transmitted to the output circuit 5, where outputting and precharging operations are performed as will be described subsequently.

The equalising signal ϕEQ is transmitted to a bit line equalising precharging control circuit 8 and is simultaneously transmitted to a common data line equalising and precharging control circuit 9. A signal which undergoes transition from the time of writing until reading is transmitted to a ϕEQW generator 7. A signal ϕEQW from the generator 7 is transmitted to the bit line equalising and precharging control circuit 8 and to the common data line equalising and precharging control circuit 9. Thus, the control circuits 8 and 9 are controlled not only by the equalising signal ϕEQ, but also by the signal ϕEQW.

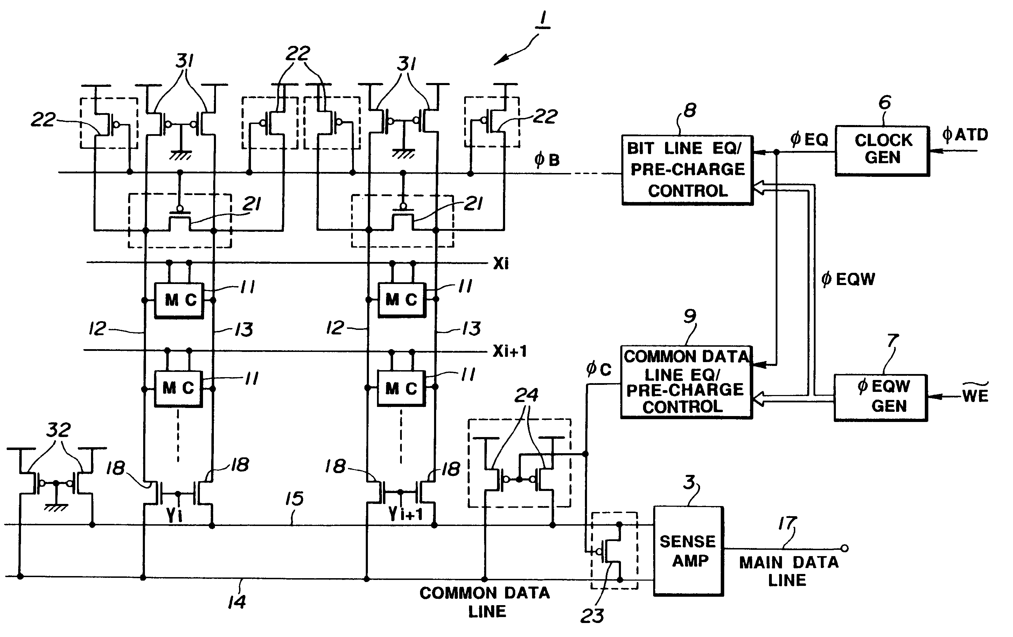

The memory cell array 1 and peripheral circuitry are shown in Figure 3. A number of memory cells (MC) 11 are arrayed in a matrix configuration with each cell 11 being connected to a pair of bit lines 12, 13. The memory cells 11 comprise flip-flops for data storage. A potential difference is produced across the bit lines 12, 13 at the time of reading and writing. Word lines Xi, Xi+1, ... , arranged at right angles to the bit lines 12, 13, are connected to the memory cells 11. Signals from a row decoder bring the word lines Xi, Xi+1, ... to a high level at the time of row selection to turn on word transistors (not shown) of the memory cells 11. A source or a drain of a pMos transistor 21 is connected to each pair of bit lines 12, 13. Each pMOS transistor 21 constitutes a bit line equalising circuit and can short-circuit the associated bit line pair 12, 13. A signal ϕB from the bit line equalising and precharging control circuit 8 is supplied to the gate of each pMOS transistor 21. Between each bit line of each bit line pair 12, 13 and the high level source voltage there is connected a pMOS transistor 22 which constitutes a bit line precharging circuit and which has its source and drain connected to a source voltage and to the bit line 12 or 13, respectively. The signal ϕB from the bit line equalising and precharging control circuit 8 is supplied to the gate of each pMOS transistor 22, similarly to the pMOS transistors 21. A bit line load transistor 31 is provided for terminating each of the bit lines 12, 13. Each bit line load transistor 31 has its source and gate connected to the source potential and to ground potential GND, respectively. A pair of nMOS transistors 18,18, functioning as a column select switch, are connected across each bit line pair 12, 13. The bit lines 12 are connected via the nMOS transistors 18 to a common data line 14 of a common data line pair 14, 15 while the bit lines 13 are connected to the common data line 15 via the nMOS transistors 18. Common column select lines Yi, Yi+1, ... , which are selectively brought to a high level by signals from a column decoder (not shown), are connected to the gates of the nMOS transistors 18, 18 associated with the bit line pairs 12, 13. The signals from the column decoder are based on the address signals and function to select a specified one of the memory cells 11 in association with the word lines Xi, Xi+1, ....

The common data line pair 14,15 functions to select a specified number of bit line pairs 12,13 in common to associated sense amplifiers 3. Each sense amplifier 3 is connected to the terminals of the common data lines 14,15 for amplifying the signal potential difference across the lines 14,15. Amain data line 17 is taken out from the sense amplifier 3 for in- put/output and is used for data outputting. A pair of pMOS transistors 32, 32 functioning as a common data line load are connected across the common data lines 14, 15. The source and the drain of a pMos transistor 23 are connected to the common data lines 14, 15. The pMOS transistor 23 constitutes a common data line equalising circuit and can short-circuit the common data line pair 14, 15. A signal ϕC from the common data line equalising and precharging control circuit 9 is supplied to the gate of the pMOS transistor 23. Between the common data line pair 14,15 and the source voltage there are connected a pair of pMOS transistors 24, 24 constituting a common data line precharging circuit, with the source and the drain of each of the pMOS transistors 24, 24 being connected to the source potential and to a respective one of the common data lines 14,15, respectively. The signal ϕC from the common data line equalising and precharging control circuit 9 is also transmitted to the gate of each of the pMOS transistors 24.

The circuitry for actuating the equalising and precharging circuitry will now be described. The equalising and the precharging operations for the bit lines 12, 13 are performed by the signal ϕB from the bit line equalising and precharging control circuit 8, while the equalising and the precharging operations for the common data lines 14,15 are performed by the signal ϕC from the common data line equalising and precharging control circuit 9. In the case of transition from writing to reading, the bit line equalising and precharging control circuit 8 and the common data line equalising and precharging control circuit 9 perform a control operation in accordance with the pulse signal ϕEQW from the ϕEQW generator 7. Thus, in case of transition from writing to reading, as later described, a high speed equalising and precharging operation may be performed. In the case of other address transitions, the control circuits 8, 9 perform necessary control operations in accordance with the pulse signal ϕEQ generated by the clock generator 6 on the basis of the signal ϕATD from the address buffer-ATD circuit 4 (Figure 2).

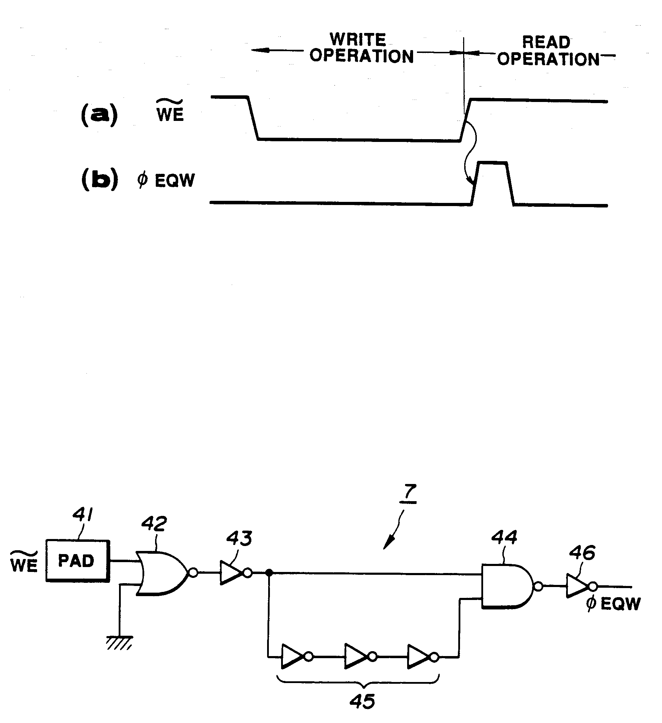

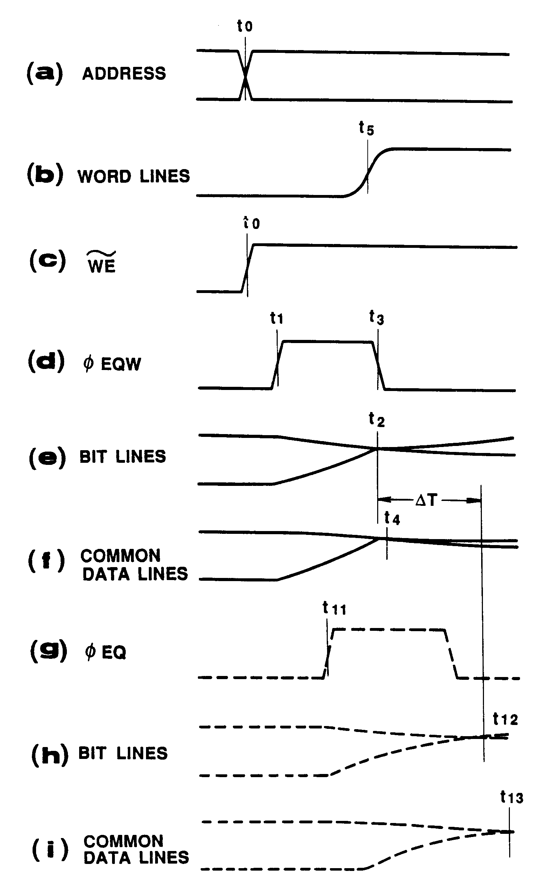

The ϕEQW generator 7 will now be described with reference to Figures 4 and 5. As shown in Figure 4, the ϕEQW generator 7 generates a pulse of the pulse signal ϕEQW when the write enable signal WE rises from low level to high level. When the write enable sig- nal WE is at the low level or at the high level, the chip is set to the write state or to the reading state, respectively. Hence, the rising of the signal WE corresponds to the transition from writing to reading and this timing of transition may be used to achieve high speed equalising and precharging.

The circuit construction of the ϕEQW generator is shown in Figure 5. A pad 41, to which the signal _{WE} is inputted, is connected to an input terminal of a two-input NOR circuit 42, which has its other input terminal grounded, while an output of the NOR circuit 42 is inputted to one input terminal of a two-input NAND circuit 44 by way of an inverter 43. An output of the inverter 43 is connected to the other input terminal of the NAND circuit 44 by way of a delay circuit 45 consisting of plural stages of inverters. The delay circuit 45 determines the pulse width of the signal ϕEQW. An output of the NAND circuit 44 is transmitted as the pulse signal ϕEQW to the bit line equalising and precharging control circuit 8 and to the common data line equalising and precharging control circuit 9 by way of an inverter 46. In this manner, the ϕEQW generator 7 directly generates pulses from the signal and collection of plural stages of address transitions is unnecessary so that the pulses of the signal ϕEQW may be transmitted at elevated speeds to the control circuits 8, 9 to shorten the write recovery time.

The operation of the above-described SRAM of the illustrative embodiment will now be explained with reference to Figures 3 and 6. The address signal shown at (a) in Figure 6 is changed at a time t0, at the same time that the write enable signal WE shown at (c) in Figure 6 is changed from the low level to the high level. With the write enable signal thus changed, the chip is switched from writing operation to reading operation.

The write enable signal is transmitted immediately to the ϕEQW generator 7 shown in Figure 3 and, at a time t1 after an extremely short time has elapsed, a pulse of the signal ϕEWQ is produced, as shown at (d) in Figure 6. This is because the pulse of the signal ϕEQW is generated with high response from the write enable signal by the ϕEQW generator 7. The thus- produced pulse of the signal ϕEQW is transmitted to the bit line equalising and precharging control circuit 8 and to the common data line equalising and precharging control circuit 9. The bit line equalising, bit line precharging, common data line equalising and common data line precharging operations are performed by the control signals ϕB, ϕC from the control circuits 8, 9. That is, at the bit lines 12,13, the pMOS transistors 21 forming the bit line equalising circuits are turned on, while the pMOS transistors 22 forming the bit line precharging circuits are turned on. The result is that the level - shown at (e) in Figure 6 - at the bit line pair, which has been swung almost fully, is raised towards the source voltage when the current flows from the high level bit line to the low level bit line by equalising, with the precharging pMOS transistors 22 turned on, until the potentials at the bit lines 12, 13 become equal to each other at a time t2. At the time t2, or at a time t3, the pulse of the signal ϕEQW ends, that is the signal ϕEQW goes low, to terminate the equalising and precharging operation. Similarly, on the common data lines 14 and 15, the pMOS transistor 23 forming the common data line equalising circuit is turned on and the pMOS transistors 24 forming the common data line precharging circuit are turned on. The result is that the level - as shown at (f) in Figure 6 - at the common data line pair, which has been swung almost fully, is raised to the source voltage by the pMOS transistors 24, with the current flowing from the high level common data line to the low level common data line by equalisation, until the potentials at the common data lines 14, 15 become equal to each other at a time t4.

In this manner, the equalising and precharging operations are performed at the bit lines 12, 13 and the common data lines 14, 15 on the basis of the signal ϕEQW and, towards the close of these operations, the potential - shown at (b) in Figure 6 - of the word line to be selected is raised at a time t5 to effect the row selecting operation. In the word line selecting operation, the word transistors of the memory cells 11 of a given column are turned on to turn on the drive transistor to cause the signal potential difference to appear across the bit lines 12, 13. Such signal potential difference is also caused to appear on the common data lines 14,15 by way of the pMOS transistors 18 forming the column select switch. The data are outputted and read out by way of the sense amplifiers 3.

For comparison, the operation of the equalising pulse signal ϕEQ based on the address buffer-ATD circuit 4 will now be explained with reference to signals shown by broken lines at (g) to (i) in Figure 6. After the change in the address signal at the time t0 and at the time of using the address buffer ATD circuit 4, a delay is caused and, at a time t11, a pulse of the signal ϕEQ - as shown at (g) in Figure 6 - is generated by the clock generator 6. As a result, the equalising and precharging operation for the level on the bit line - see (h) in Figure 6 - and the level on the common data line - see (i) in Figure 6 - is performed with a delay as compared to the case of the ϕEQW pulse signal. At a time t12 the levels of the bit line pair become equal, and, at a time t13, the levels of the common data line pair become equal. With a time difference of approximately AT at the bit lines as compared to the case of the pulse signal ϕEQW, it can be seen that a higher speed may be realised when the equalising and precharging operation is carried out by generating the pulses of the ϕEQW signal by the ϕEQW pulse generator 7 on the basis of the write enable signal W9.

With the SRAM of the present embodiment, a pulse of the ϕEQW signal is generated at an elevated speed by the ϕEQW pulse generator 7 from the write enable signal WE, at the time of transition from the write operation to the readout operation, despite the fully swung state of the bit lines and the common data lines, to perform the equalising and precharging operation, so that high speed access can be realised, while the word line can be selected at a high speed to prevent data destruction in the memory cell.

Although both the bit lines and the common data lines are both equalised and precharged in the above embodiment, it is possible for only the common data lines to be equalised and/or precharged. Although the precharging and equalising circuits are each formed by pMOS transistors, other transistor types may also be used in combination. Similarly, for selecting the impedance, the threshold voltage Vth, the signal level supplied to the base or the gate, or the element size can be selected. The bit line load or the common data line load can be formed as variable load means.

Ways in which the output circuit 5 used as an output buffer on the SRAM of the present illustrative embodiment can be constructed are described in the specification of this application as published under the number EP-A-0 384 673 and in the specification of European Patent Application No. 94200916.8 which has been divided from this application.

## Claims

1. A memory device comprising:
a plurality of memory cells (11) arranged in a matrix configuration and composed of flip-flop circuits for data storage;
a plurality of pairs of bit lines (12,13), each coupled to a column of the memory cells (11), for handling complementary read-out data or write data;
a plurality of word lines (Xi etc), one for each row of the memory cells (11), for selecting rows of the memory cells;
a sense amplifier (3) connectable to a pair of bit lines (12, 13) for amplifying the voltage across the pair of bit lines;
equalising means (23) operative transiently prior to memory cell selection by a word line (Xi etc) to equalise a pair of lines by setting the lines to the same potential;
equalising control means (9) for setting the operating time interval for the equalising means (23);
first signal generating means (4, 6) responsive to an address signal supplied for selection of the word lines (Xi etc) and the bit lines (12, 13) to generate a signal for actuating the equalising control means (9); and
second signal generating means (7) operative to detect a transition from writing to read- out;
characterised in that:
the memory cells (11), the bit lines (12, 13), the word lines (Xi etc), the sense amplifier (3), the equalising means (23), the equalising control means (9), the first signal generating means (4, 6) and the second signal generating means (7) are all formed on a major surface of a semiconductor substrate;
a plurality of pairs of common data lines (14, 15) are formed on said major surface and each pair is connected in common by column select switches (18) to a plural number of bit line pairs (12, 13) for handling complementary read- out data or write data;
the sense amplifier (3) is connected to a pair of common data lines (14, 15);
the equalising means (23) acts as common data line equalising means in that it is operative to equalise a pair of common data lines (14, 15); and
the second signal generating means (7) is operative to actuate the equalising control means (9) at the time said transition is detected.

2. A memory device according to claim 1, comprising bit line equalising means (21) formed on said major surface and operative transiently prior to memory cell selection by a word line (Xi etc) to equalise a pair of the bit lines (12, 13), the equalising control means (8, 9) being operative to control the bit line equalising means (21) and the common data line equalising means (23).

3. A memory device comprising:
a plurality of memory cells (11) arranged in a matrix configuration and composed of flip-flop circuits for data storage;
a plurality of pairs of bit lines (12,13), each coupled to a column of the memory cells (11), for handling complementary read-out data or write data;
a plurality of word lines (Xi etc), one for each row of the memory cells (11), for selecting rows of the memory cells;
a sense amplifier (3) connectable to a pair of bit lines (12, 13) for amplifying the voltage across the pair of bit lines;
precharging means (24) operative transiently prior to memory cell selection by a word line (Xi etc) to precharge a pair of lines by connecting the lines to a potential source;
precharging control means (9) for setting the operating time interval for the precharging means (24);
first signal generating means (4, 6) responsive to an address signal supplied for selection of the bit lines (12, 13); and
second signal generating means (7) operative to detect a transition from writing to read- out and to actuate the precharging control means (9) at the time said transition is detected;
characterised in that:
the memory cells (11), the bit lines (12, 13), the word lines (Xi etc), the sense amplifier (3), the precharging means (24), the precharging control means (9), the first signal generating means (4, 6) and the second signal generating means (7) are all formed on a major surface of a semiconductor substrate;
a plurality of pairs of common data lines (14, 15) are formed on said major surface and each pair is connected in common by column select switches (18) to a plural number of bit line pairs (12, 13) for handling complementary read- out data or write data;
the sense amplifier (3) is connected to a pair of common data lines (14, 15);
the first signal generating means (4, 6) is responsive to the address signal supplied for selection of the bit lines (12, 13) to generate a signal for activating the precharging control means (9); and
the precharging means (24) acts as common data line precharging means in that it is operative to precharge a pair of common data lines (14, 15).

4. A memory device according to claim 3, comprising bit line precharging means (22) formed on said major surface and operative transiently prior to memory cell selection by a word line (Xi etc) to precharge a pair of the bit lines (12, 13) the precharging control means (8, 9) being operative to control the bit line precharging means (22) and the common data line precharging means (24).

5. A memory device according to claim 4, comprising
first equalising means (23) operative transiently prior to memory cell selection by a word line (Xi etc) to equalise each of a pair of the common data lines (14, 15),
second equalising means (21) operative transiently prior to selection of a memory cell (11) by a word line (Xi etc) to equalise each of a pair of the bit lines (12, 13), and
equalising control means (8, 9) formed on said major surface for controlling each of the first and second equalising means (23, 21),
both the equalising control means (8, 9) and the precharging control means (8, 9) being arranged to be controlled by a signal from each of the first signal generating means (4, 6) and the second signal generating means (7).

6. A memory device according to claim 3, comprising
equalising means (23) formed on said major surface and operative transiently prior to memory cell selection by a word line (Xi etc) to equalise a pair of the common data lines (14,15), and equalising control means (8, 9) formed on said major surface for setting the operating time interval for the equalising means (23),
both the equalising control means (8, 9) and the precharging control means (8, 9) being arranged to be actuated by a signal from each of the first signal generating means (4, 6) and the second signal generating means (7).

7. A memory device according to any one of the preceding claims, wherein the second signal generating means (7) is operative to detect a transition from writing to read-out on the basis of a write enable signal.

## Patentansprüche

1. Speichereinrichtung, bestehend aus:
mehreren in einer Matrixkonfiguration angeordneten und aus Flipflop-Schaltungen für Datenspeicherung gebildeten Speicherzellen (11), mehreren Paaren Bitleitungen (12, 13), deren jedes an eine Spalte der Speicherzellen (11) zum komplementären Ausführen eines Datenauslesens und Datenschreibens gekoppelt ist, mehreren pro Reihe der Speicherzellen (11) einzeln vorgesehenen Wortleitungen (Xi usw.) zum Auswählen von Reihen der Speicherzellen, einem mit einem Paar Bitleitungen (12, 13) verbindbaren Abtastverstärker (3) zum Verstärken der Spannung über dem Paar Bitleitungen, einer vor der Speicherzellenauswahl durch eine Wortleitung (Xi usw.) vorübergehend betreibbaren Ausgleichseinrichtung (23) zum Ausgleichen eines Paares Leitungen durch Einstellen der Leitungen auf das gleiche Potential,
einer Ausgleichssteuereinrichtung (9) zum Einstellen des Betriebszeitintervalls für die Ausgleichseinrichtung (23),
einer auf ein zur Auswahl der Wortleitungen (Xi usw.) und der Bitleitungen (12, 13) zugeführtes Adressensignal ansprechenden ersten Signalerzeugungseinrichtung (4, 6) zum Erzeugen eines Signals zum Aktivieren der Ausgleichssteuereinrichtung (9) und
einer zweiten Signalerzeugungseinrichtung (7) zum Detektieren eines Übergangs vom Schreiben zum Auslesen,
dadurch gekennzeichnet, daß
die Speicherzellen (11), die Bitleitungen (12,13), die Wortleitungen (Xi usw.), der Abtastverstärker
(3), die Ausgleichseinrichtung (23), die Ausgleichssteuereinrichtung (9), die erste Signalerzeugungseinrichtung (4, 6) und die zweite Signalerzeugungseinrichtung (7) alle auf einer Hauptfläche eines Halbleitersubstrats ausgebildet sind,
mehrere Paare gemeinsamer Datenleitungen (14, 15) auf der Hauptfläche ausgebildet sind und jedes Paar gemeinsam durch Spaltenauswahlschalter (18) mit einer Anzahl Bitleitungspaaren (12, 13) zum komplementären Ausführen eines Datenauslesens und Datenschreibens verbunden ist,
der Abtastverstärker (3) mit einem Paar gemeinsamer Datenleitungen (14, 15) verbunden ist, die Ausgleichseinrichtung (23) als eine Ausgleichseinrichtung für gemeinsame Datenleitungen derart wirkt, daß ein Paar gemeinsamer Datenleitungen (14, 15) ausgeglichen wird, und die zweite Signalerzeugungseinrichtung (7) die Ausgleichssteuereinrichtung (9) zum Zeitpunkt des Detektierens des Übergangs aktiviert.

2. Speichereinrichtung nach Anspruch 1, mit einer auf der Hauptfläche ausgebildeten Bitleitungs-Ausgleichseinrichtung (21), die vor einer Speicherzellenauswahl durch eine Wortleitung (Xi usw.) vorübergehend ein Paar der Bitleitungen (12, 13) ausgleicht, wobei die Ausgleichssteuereinrichtung (8, 9) die Bitleitungs-Ausgleichseinrichtung (21) und die Ausgleichseinrichtung (23) für gemeinsame Datenleitungen steuert.

3. Speichereinrichtung, bestehend aus:
mehreren in einer Matrixkonfiguration angeordneten und aus Flipflop-Schaltungen für Datenspeicherung bestehenden Speicherzellen (11), mehreren Paaren Bitleitungen (12,13), deren jedes an eine Spalte aus den Speicherzellen (11) zum komplementären Ausführen eines Datenauslesens und Datenschreibens gekoppelt ist, mehreren pro Reihe der Speicherzellen (11) einzeln vorgesehen Wortleitungen (Xi usw.) zum Auswählen von Reihen der Speicherzellen,
einem mit einem Paar Bitleitungen (12, 13) verbindbaren Abtastverstärker (3) zum Verstärken der Spannung über dem Paar Bitleitungen, einer vor einer Speicherzellenauswahl durch eine Wortleitung (Xi usw.) vorübergehend betreibbaren Voraufladungseinrichtung (24) zum Voraufladen eines Paares Leitungen durch Verbinden der Leitungen mit einer Potentialquelle,
einer Voraufladungssteuereinrichtung (9) zum Einstellen des Betriebszeitintervalls für die Voraufladungseinrichtung (24), einer auf ein zurAuswahl der Bitleitungen (12,13) zugeführtes Adressensignal ansprechenden ersten Signalerzeugungseinrichtung (4, 6) , und
einer zweiten Signalerzeugungseinrichtung (7) zum Detektieren eines Übergangs vom Schreiben zum Auslesen und Aktivieren der Voraufladungssteuereinrichtung zum Zeitpunkt eines Detektierens des Übergangs,
dadurch gekennzeichnet, daß
die Speicherzellen (11), die Bitleitungen (12,13), die Wortleitungen (Xi usw.), der Abtastverstärker (3), die Voraufladungseinrichtung (24), die Voraufladungssteuereinrichtung (9), die erste Signalerzeugungseinrichtung (4, 6) und die zweite Signalerzeugungseinrichtung (7) alle auf einer Hauptfläche eines Halbleitersubstrats ausgebildet sind,
mehrere Paare gemeinsamer Datenleitungen (14, 15) auf der Hauptfläche ausgebildet sind und jedes Paar gemeinsam durch Spaltenauswahlschalter (18) mit einer Anzahl Bitleitungspaaren (12,13) zum komplementären Ausführen eines Datenauslesens und Datenschreibens verbunden ist,
die erste Signalerzeugungseinrichtung (4, 6) auf das zur Auswahl der Bitleitungen (12, 13) zugeführte Adressensignal zur Erzeugung eines Signals zum Aktivieren der Voraufladungssteuereinrichtung (9) anspricht, und
die Voraufladungseinrichtung derart als eine Voraufladungseinrichtung fürgemeinsame Datenleitung wirkt, daß ein Paar gemeinsamer Datenleitungen (14, 15) voraufgeladen wird.

4. Speichereinrichtung nach Anspruch 3, mit einer auf der Hauptfläche ausgebildeten Bitleitungs-Voraufladungseinrichtung (22), die vor einer Speicherzellenauswahl durch eine Wortleitung (Xi usw.) vorübergehend ein Paar der Bitleitungen (12, 13) vorauflädt, wobei die Voraufladungssteuereinrichtung (8, 9) die Bitleitungs-Voraufladungseinrichtung (22) und die Voraufladungseinrichtung (24) für gemeinsame Datenleitungen steuert.

5. Speichereinrichtung nach Anspruch 4 mit
einer ersten Ausgleichseinrichtung (23), die vor einer Speicherzellenauswahl durch eine Wortleitung (Xi usw.) vorübergehend eines Paar der gemeinsamen Datenleitungen (14, 15) ausgleicht, einer zweiten Ausgleichseinrichtung (21), die vor einer Auswahl einer Speicherzelle (11) durch eine Wortleitung (Xi usw.) vorübergehend ein Paar der Bitleitungen (12, 13) ausgleicht, und
einer auf der Hauptfläche ausgebildeten Ausgleichssteuereinrichtung (8, 9) zum Steuern der ersten und zweiten Ausgleichseinrichtung (23, 21), wobei
sowohl die Ausgleichssteuereinrichtung (8, 9) als auch die Voraufladungssteuereinrichtung (8, 9) so ausgebildet sind, daß sie durch ein Signal sowohl aus der ersten Signalerzeugungseinrichtung (4, 6) als auch der zweiten Signalerzeugungseinrichtung (7) steuerbar sind.

6. Speichereinrichtung nach Anspruch 3, mit einer auf der Hauptfläche ausgebildeten Ausgleichseinrichtung (23), die vor einer Speicherzellenauswahl durch eine Wortleitung (Xi usw.) vorübergehend ein Paar der gemeinsamen Datenleitungen (14, 15) ausgleicht, und
einer auf der Hauptfläche ausgebildeten Ausgleichssteuereinrichtung (8, 9) zum Einstellen des Betriebszeitintervalls für die Ausgleichseinrichtung (23),
wobei sowohl die Ausgleichssteuereinrichtung (8, 9) als auch die Voraufladungseinrichtung (8,
9) so ausgebildet sind, daß sie durch ein Signal sowohl aus der ersten Signalerzeugungseinrichtung (4, 6) als auch der zweiten Signalerzeugungseinrichtung (7) aktivierbar sind.

7. Speichereinrichtung nach einem der vorhergehenden Ansprüche, wobei die zweite Signalerzeugungseinrichtung (7) einen Übergang vom Schreiben zum Auslesen auf der Basis eines Schreibfreigabesignals detektiert.

## Revendications

1. Dispositif de mémoire comprenant :
une pluralité de cellules de mémoire (11) agencées selon une configuration de matrice et composées de circuits de bascule pour le stockage de données ;
une pluralité de paires de lignes de bit (12, 13), chacune d'entre elles étant couplée à une colonne des cellules de mémoire (11), pour traiter des données d'écriture ou des données de lecture complémentaires ;
une pluralité de lignes de mot (Xi, etc.), une pour chaque rangée des cellules de mémoire (11), pour sélectionner des rangées des cellules de mémoire ;
un amplificateur de détection (3) connectable à une paire de lignes de bit (12,13) pouram- plifier la tension entre la paire de lignes de bit ;
un moyen d'égalisation (23) fonctionnant de façon transitoire avant la sélection de cellules de mémoire par une ligne de mot (Xi, etc.) pour égaliser une paire de lignes en établissant les lignes au même potentiel ;
un moyen de commande d'égalisation (9) pour établir l'intervalle de temps de fonctionnement pour le moyen d'égalisation (23) ;
un premier moyen de génération de signal (4, 6) sensible à un signal d'adresse généré pour la sélection des lignes de mot (Xi, etc.) et des lignes de bit (12, 13) pour générer un signal permettant d'actionner le moyen de commande d'égalisation (9) ; et
un second moyen de génération de signal (7) servant à détecter une transition de l'écriture à la lecture ;
caractérisé en ce que :
les cellules de mémoire (11), les lignes de bit (12, 13), les lignes de mot (Xi, etc.), l'amplificateur de détection (3), le moyen d'égalisation (23), le moyen de commande d'égalisation (9), le premier moyen de génération de signal (4, 6) et le second moyen de génération de signal (7) sont tous formés sur une surface principale d'un substrat semiconducteur ;
une pluralité de paires de lignes de données communes (14, 15) sont formées sur ladite surface principale et chaque paire est connectée en commun par des commutateurs de sélection de colonne (18) à un nombre supérieur à un de paires de lignes de bit (12, 13) pour traiter des données d'écriture ou des données de lecture complémentaires ;
l'amplificateur de détection (3) est connecté à une paire de lignes de données communes (14, 15) ;
Le moyen d'égalisation (23) agit en tant que moyen d'égalisation de lignes de données communes de façon à ce qu'il fonctionne afin d'égaliser une paire de lignes de données communes (14, 15) ; et
le second moyen de génération de signal (7) fonctionne afin de mettre en fonctionnement le moyen de commande d'égalisation (9) à l'instant où ladite transition est détectée.

2. Dispositif de mémoire selon la revendication 1, comprenant un moyen d'égalisation de ligne de bit (21) formé sur ladite surface principale etfonc- tionnant de façon transitoire avant la sélection de cellules de mémoire par une ligne de mot (Xi, etc.) afin d'égaliser une paire des lignes de bit (12, 13), le moyen de commande d'égalisation (8, 9) fonctionnant afin de commander le moyen d'égalisation de ligne de bit (21) et le moyen d'égalisation de ligne de données communes (23).

3. Dispositif de mémoire comprenant :
une pluralité de cellules de mémoire (11) agencées selon une configuration de matrice et composées de circuits de bascule pour le stockage de données ;
une pluralité de cellules de mémoire (11) agencées selon une configuration de matrice et composées de circuits de bascule pour le stockage de données ;
une pluralité de paires de lignes de bit (12, 13), chacune d'entre elles étant couplée à une colonne des cellules de mémoire (11), pour traiter des données d'écriture ou des données de lecture complémentaires ;
une pluralité de lignes de mot (Xi, etc.), une pour chaque rangée des cellules de mémoire (11), pour sélectionner des rangées des cellules de mémoire ;
un amplificateur de détection (3) connectable à une paire de lignes de bit (12, 13) pouram- plifier la tension entre la paire de lignes de bit ;
un moyen de préchargement (24) fonctionnant de façon transitoire avant la sélection de cellules de mémoire par une ligne de mot (Xi, etc.) pour précharger une paire de lignes en connectant les lignes à une source de tension ;
un moyen de commande de préchargement (9) permettant d'établir l'intervalle de temps de fonctionnement pour le moyen de préchargement (24) ;
un premier moyen de génération de signal (4, 6) sensible à un signal d'adresse généré pour une sélection des lignes de bit (12, 13) ; et
un second moyen de génération de signal (7) servant à détecter une transition de l'écriture à la lecture et à actionner le moyen de commande de préchargement (9) à l'instant où ladite transition est détectée ;
caractérisé en ce que :
les cellules de mémoire (11), les lignes de bit (12, 13), les lignes de mot (Xi, etc.), l'amplificateur de détection (3), le moyen de préchargement (24), le moyen de commande de préchargement (9), le premier moyen de génération de signal (4, 6) et le second moyen de génération de signal (7) sont tous formés sur une surface principale d'un substrat semiconducteur ;
une pluralité de paires de lignes de données communes (14, 15) sont formées sur ladite surface principale et chaque paire est connectée en commun par des connecteurs de sélection de colonne (18) à un nombre supérieur à un de paires de lignes de bit (12, 13) pour traiter des données d'écriture ou des données de lecture complémentaires ;
l'amplificateur de détection (3) est connecté à une paire de lignes de données communes (14, 15) ;
le premier moyen de génération de signal (4, 6) est sensible au signal d'adresse généré pour la sélection des lignes de bit (12, 13) pour générer un signal permettant d'actionner le moyen de commande de préchargement (9) ; et
le moyen de préchargement (24) agit en tant que moyen de préchargement de lignes de données communes de façon à ce qu'il fonctionne pour précharger une paire de lignes de données communes (14, 15).

4. Dispositif de mémoire selon la revendication 3, comprenant un moyen de préchargement de lignes de bit (22) formé sur ladite surface principale et fonctionnant de façon transitoire avant la sélection de cellules de mémoire par une ligne de mot (Xi, etc.) pour précharger une paire des lignes de bit (12, 13), le moyen de commande de préchargement (8, 9) fonctionnant pourcomman- der le moyen de préchargement de lignes de bit (22) et le moyen de préchargement de lignes de données communes (24).

5. Dispositif de mémoire selon la revendication 4, comprenant :
un premier moyen d'égalisation (23) fonctionnant de façon transitoire avant la sélection de cellules de mémoire par une ligne de mot (Xi, etc.) pour égaliser chaque ligne d'une paire des lignes de données communes (14, 15),
un second moyen d'égalisation (21) fonctionnant de façon transitoire avant la sélection d'une cellule de mémoire (11) par une ligne de mot (Xi, etc.) pour égaliser chaque ligne d'une paire des lignes de bit (12, 13), et
un moyen de commande d'égalisation (8, 9) formé sur ladite surface principale pour commander chacun des premier et second moyens d'égalisation (23, 21),
Ala fois le moyen de commande d'égalisation (8, 9) et le moyen de commande de préchargement (8, 9) étant agencés de manière à être commandés par un signal provenant de chaque moyen parmi le premier moyen de génération de signal (4, 6) et le second moyen de génération de signal (7).

6. Dispositif de mémoire selon la revendication 3, comprenant :
un moyen d'égalisation (23) formé sur ladite surface principale et fonctionnant de façon transitoire avant la sélection de cellules de mémoire par une ligne de mot (Xi, etc.) pour égaliser une paire des lignes de données communes (14, 15), et
un moyen de commande d'égalisation (8, 9) formé sur ladite surface principale pour établir l'intervalle de temps de fonctionnement pour le moyen d'égalisation (23),
A la fois le moyen de commande d'égalisation (8, 9) et le moyen de commande de préchargement (8,9) étant agencés de manière à être actionnés par un signal provenant de chaque moyen parmi le premier moyen de génération de signal (4, 6) et le second moyen de génération de signal (7).

7. Dispositif de mémoire selon une quelconque des revendications précédentes, dans lequel le second moyen de génération de signal (7) sert à détecter une transition de l'écriture à la lecture en se basant sur un signal de validation d'écriture.
